Europäisches Patentamt

European Patent Office

Office européen des brevets

(11) Publication number: **0 445 323 A1**

## EUROPEAN PATENT APPLICATION

(21) Application number: 90104279.6

(22) Date of filing: 06.03.90

(51) Int. Cl.5: **H01L 21/82**, H01L 21/76, H01L 27/092, H01L 29/08, H01L 21/74

(43) Date of publication of application:
11.09.91 Bulletin 91/37

(84) Designated Contracting States:
DE FR GB

(71) Applicant: Kabushiki Kaisha Toshiba
72, Horikawa-cho Saiwai-ku
Kawasaki-shi(JP)

(72) Inventor: Shirai, Koji, c/o Intellectual Property
Division
K.K. Toshiba, 1-1 Shibaura 1-chome
Minato-ku, Tokyo 105(JP)

(74) Representative: Lehn, Werner, Dipl.-Ing. et al
Hoffmann, Eitle & Partner Patentanwälte
Arabellastrasse 4
W-8000 München 81(DE)

(54) Field effect semiconductor device having current paths formed in conductive layer of semiconductor substrate.

(57) A pot-like hole with a bottom is formed by etching part of one major surface of a semiconductor substrate (1) of a first conductivity type. A buried layer (9) is formed on the surface of the pot-like hole. A semiconductor layer (10) of a second conductivity type is formed to fill a space inside the buried layer (9), and is electrically isolated from the semiconductor substrate (1) of the first conductivity type by the buried layer (9). A first FET (Field Effect Transistor) (Q1), having a channel with current paths extending through the semiconductor substrate (1), is formed on one major surface of the semiconductor substrate (1) of the first conductivity type. A second FET (Q2) having a channel with current paths extending through the semiconductor layer (10) of the second conductivity type is formed on the semiconductor layer (10) of the second conductivity type which is located on the buried layer (9).

F I G. 1

The present invention relates to an IC element having a high breakdown voltage, which is generally used to drive an IC and, more particularly, to a field effect semiconductor device having current paths formed in its semiconductor substrate.

A circuit element having a high breakdown voltage, which is generally used as a driver of an IC, is fabricated such that p- and n-channel DMOS FETs are formed on the same major surface of a semiconductor substrate.

For example, $n^-$-type silicon layers are formed on a p-type semiconductor substrate to sandwich each $n^+$-type silicon buried layer, and the $n^-$-type silicon layers are divided into island regions by the wall of a $p^+$-type silicon isolation layer and are electrically isolated from each other. If an n-channel DMOS FET is formed on one of the $n^-$-type silicon layers, a p-channel DMOS FET must be formed on the other $n^-$-type silicon layer. Therefore, current paths and a p-type high-resistance layer as a drain region are formed on a surface of each $n^-$-type silicon layer by surface diffusion or the like.

Since the current paths and the drain region are formed on the surface of the substrate, the conventional p-channel DMOS FET has limitations in the width and depth directions. Therefore, the sectional areas of the current paths and the drain regions are undesirably limited in relation to the total area of the IC.

In the conventional p-channel DMOS FET, a current flowing through only a portion near the major surface is increased, and the ON resistance of each gate is considerably higher than in the n-channel DMOS FET. In addition, in the conventional p-channel DMOS FET, since a drain-drift layer (high resistance layer) is formed in the diffusion layer, extension of the depletion layer from the drain PN junction to the drain-drift layer is restricted. Hence, a sufficient breakdown voltage cannot be obtained. Moreover, the conventional p-channel DMOS FET has a drawback that the switching speed is low because of the high ON resistance.

It is an object of the present invention to provide a field effect semiconductor device which allows a reduction in ON resistance of a gate so as to increase the breakdown voltage, and which can increase the switching speed.

According to the present invention, there is provided a field effect semiconductor device having current paths formed in a conductive layer of a semiconductor substrate, comprising a pot-like buried layer formed in a semiconductor substrate of a first conductivity type, a semiconductor layer of a second conductivity type which is formed to fill a space inside the buried layer and is electrically isolated from the semiconductor substrate of the first conductivity type through the buried layer, a first FET formed on the semiconductor substrate of the first conductivity type and having a channel of the first conductivity type and a drain electrode a part of which is constituted by the conductive layer of the semiconductor substrate, and a second FET formed on the semiconductor layer of the second conductivity type and having a channel of the second conductivity type which is constituted by the semiconductor layer of the second conductivity type.

Additional objects and advantages of the invention will be set forth in the description which follows, and in part will be obvious from the description, or may be learned by practice of the invention. The objects and advantages of the invention may be realized and obtained by means of the instrumentalities and combinations particularly pointed out in the appended claims.

This invention can be more fully understood from the following detailed description when taken in conjunction with the accompanying drawings, in which:

Fig. 1 is a sectional view showing a field effect semiconductor device according to an embodiment of the present invention;

Figs. 2A to 2O are sectional views showing the steps in manufacturing the field effect semiconductor device of the present invention shown in Fig. 1; and

Fig. 3 is a sectional view, showing current paths, for explaining the operation of the present invention.

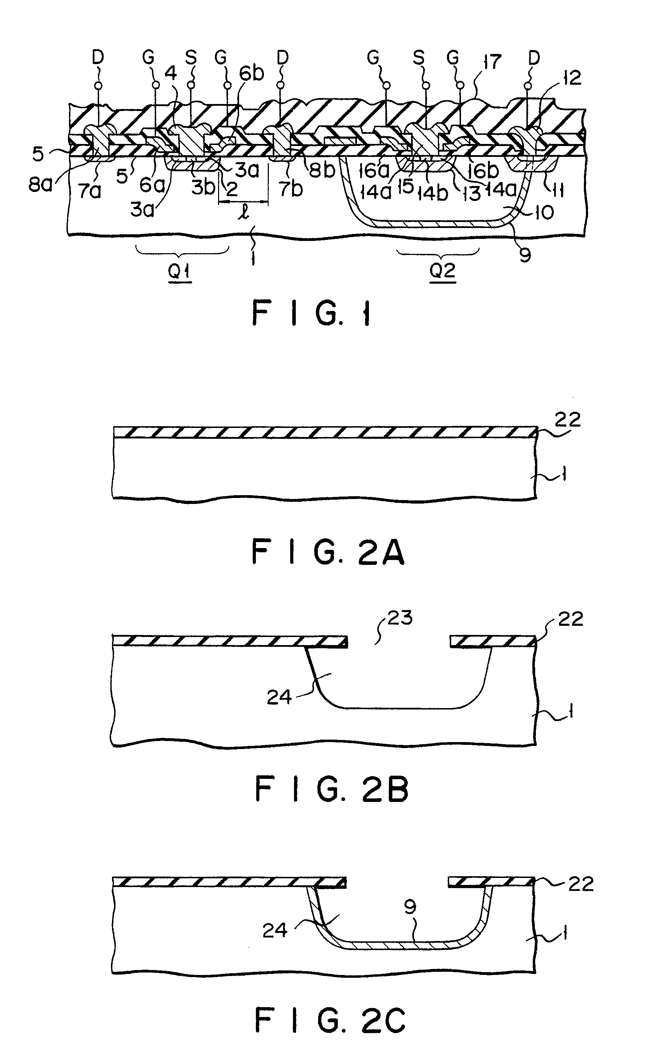

An embodiment of the present invention will be described below with reference to the accompanying drawings. Fig. 1 shows a sectional structure of a field effect semiconductor device according to an embodiment of the present invention. More specifically, the field effect semiconductor device is designed such that a p-channel first field effect transistor (FET) Q1 is formed on a semiconductor substrate 1 having a $p^-$-type conductivity, and an n-channel second FET Q2 is formed on an $n^-$-type semiconductor layer formed on the semiconductor substrate 1.

The first FET Q1 is designed such that an n-type source region 2 is formed in the p-type semiconductor substrate 1, and a source diffusion layers 3a, 3b is formed on the source region 2. The source diffusion layers 3a, 3b consists of an n-type silicon layer 3b formed at the center of the source region 2 and p-type silicon layers 3a formed on both of its sides. A source electrode 4 consisting of aluminum or an aluminum alloy is formed on part of the surface of the source diffusion layers 3a, 3b. A pair of gate electrodes 6a and 6b each consisting of polysilicon are formed on the source diffusion layers 3a, 3b through an insulating film 5 formed around the source electrode 4.

In addition, drain regions 7a and 7b are formed on the p-type semiconductor substrate 1 so as to be separated from the gate electrodes 6a and 6b respectively by a predetermined length $\ell$, and drain electrodes 8a and 8b are formed to be respectively connected to the drain regions 7a and 7b.

The second FET Q2 is designed such that an electrically-isolated pot-like $n^+$-type buried layer 9 is formed in the p-type semiconductor substrate 1, and an $n^-$-type silicon layer 10 is deposited inside the $n^+$-type silicon buried layer 9. A drain region 11 consisting of n-type and $n^+$-type silicon layers is formed on one end of the $n^+$-type silicon buried layer 9. In addition, a drain electrode 12 is formed on the drain region 11.

A source region 13 consisting of a p-type silicon layer is formed in the $n^-$-type silicon layer 10. A source diffusion layers 14a consisting of n-type silicon is formed on part of the source region 13, a p-type back gate electrode extraction layer 14b being sandwiched therebetween. A source electrode 15 is formed on the source diffusion layers 14a and 14b. A pair of gate electrodes 16a and 16b each consisting of polysilicon are formed on the source diffusion layer 14a through the insulating film 5.

A PSG (Phosphor Doped Silicate Glass) layer 17 having a thickness of about 1 $\mu$m as a top passivation layer is formed on the uppermost layer of the semiconductor substrate 1. A bonding pad (not shown) is formed on the semiconductor substrate 1.

Since the single pot-like buried layer 9 is used as an isolation layer, the silicon layer 10 is electrically isolated from the substrate 1 completely, and the reliability of this isolation is high compared with a conventional partition structure using several layers.

In this embodiment, the buried layer has a pot-like shape. However, the buried layer may have a rectangular or semicircular shape as long as the semiconductor substrate 1 and the silicon layer 10 are completely isolated from each other.

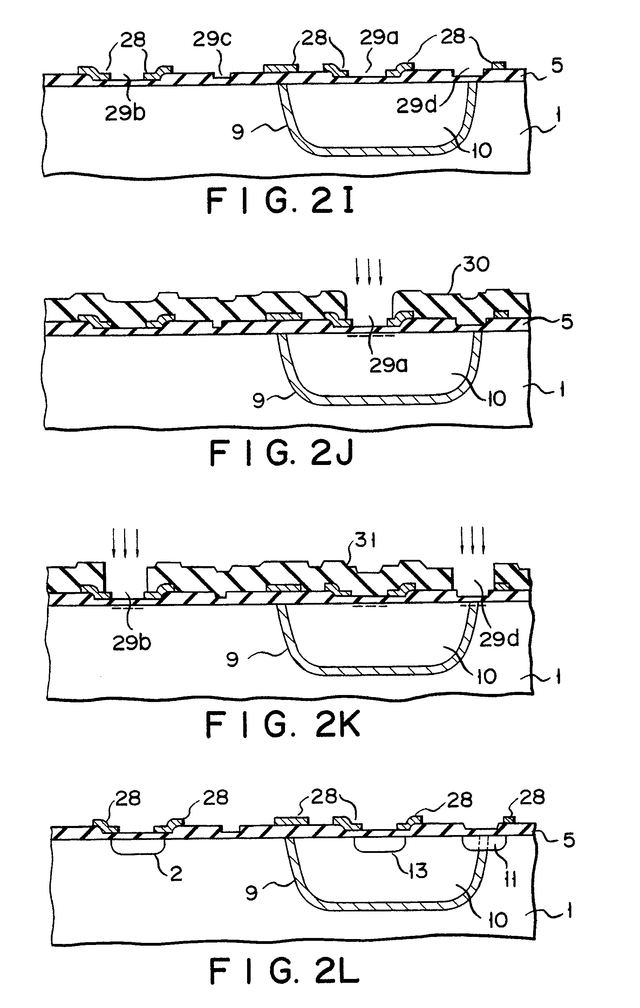

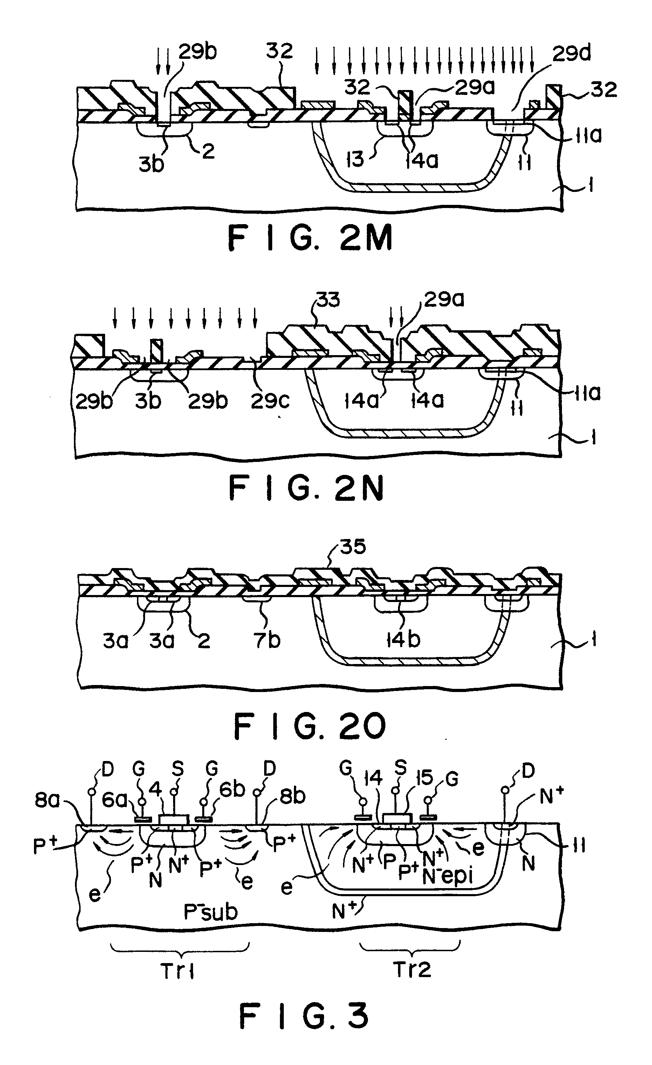

Figs. 2A to 2O show the steps in manufacturing the field effect semiconductor device according to the embodiment of the present invention (note that the same reference numerals in Figs. 2A to 2D denote the same parts as in Fig. 1).

In the step shown in Fig. 2A, a semiconductor having a first conductivity is used as a p-type silicon substrate 1, and the major surface of the p-type silicon substrate 1 is subjected to steam oxidation at a steam temperature of 1,000°C so as to form a silicon oxide film (to be referred to as an oxide film hereinafter) 22 having a thickness of about 1 $\mu$m.

In the step shown in Fig. 2B, part of the oxide film 22 is dissolved and removed by, e.g., the photo-engraving process (PEP) to form a window 23. In addition, part of the silicon substrate 1 exposed in the window 23 is etched by an etching solution (HF + HNO₃) using the oxide film 22 as a mask so as to form a pot-like hole 24 having a bottom and a depth of about 30 $\mu$m.

In the step shown in Fig. 2C, antimony (Sb) is supplied to the surface of the hole 24 formed in the silicon substrate 1 so as to perform thermal diffusion, thus forming an $n^+$-type silicon buried layer 9.

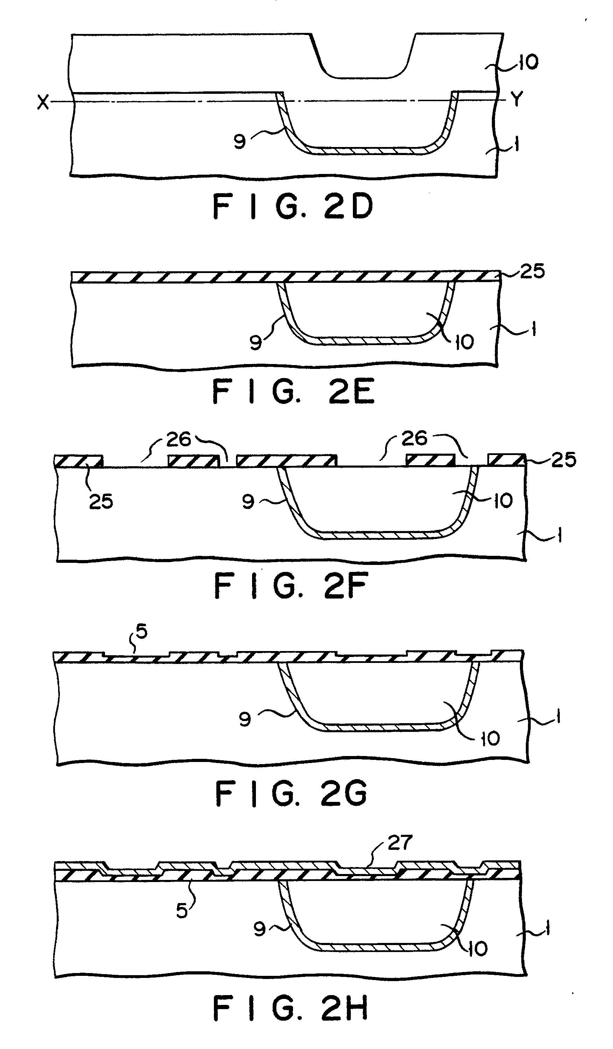

In the step shown in Fig. 2D, the oxide film 22 is dissolved and removed by an etching solution (HF) first. An $n^-$-type epitaxial growth layer 10 is formed as a semiconductor layer having a second conductivity type on the silicon substrate 1 including the hole 24 by an epitaxial growth method. A portion from the surface of the $n^-$-type epitaxial growth layer 10 to the surface indicated by a line X - Y is removed by a mechanical or chemical grinding means so as to flatten the major surface of the silicon substrate 1.

In the step shown in Fig. 2E, steam oxidation of the major surface of the silicon substrate 1 is performed at a steam temperature of 1,000°C so as to form an oxide film 25 having a thickness of about 0.8 $\mu$m.

In the step shown in Fig. 2F, portions of the oxide film 25, which are located at prospective regions of electrodes respectively constituting an n-channel DMOS FET and a p-channel DMOS FET on the major surface of the silicon substrate 1, are selectively removed to form several windows 26.

In the step shown in Fig. 2G, thermal oxidation of the silicon substrate 1 is performed to form an oxide film 5 on the oxide film 25 and the windows 26. In the thermal oxidation, the oxide film is formed by introducing dry oxygen into an atmosphere having a temperature of 1,000°C.

In the step shown in Fig. 2H, a 0.5 $\mu$m thick polysilicon film 27 is formed on the oxide film 5.

In the step shown in Fig. 2I, the polysilicon film 27 is selectively etched to leave only portions corresponding to gate electrodes 28 of the n-channel and p-channel DMOS-FETs. Electrodes are respectively formed at windows 29a, 29b, 29c, and 29d.

In the step shown in Fig. 2J, a photoresist layer 30 is formed on the major surface of the silicon substrate 1 so as to open part of the window 29a. Subsequently, boron (B) ions are implanted in the silicon substrate 1 at an acceleration voltage of 50 keV and a dose of 1 x 10¹⁴ cm². 

In the step shown in Fig. 2K, after the photoresist layer 30 is removed, a photoresist layer 31 is formed on the silicon substrate 1 so as to open parts of the windows 29b and 29d. Phosphorus (P) ions are then implanted in the silicon substrate 1 at an acceleration voltage of 100 keV and a dose of $5 \times 10^{13}$ cm². In this case, peak concentration is set at about $1 \times 10^{17}$ cm⁻³.

In the step shown in Fig. 2L, after the photoresist layer 31 is removed, heat treatment of the silicon substrate 1 is performed in a nitrogen gas atmosphere at 1,200°C for one hour.

With this heat treatment, the implanted boron ions are diffused in the silicon substrate 1, and an n-type silicon portion which is in contact with the oxide film 5 in the window 29a is formed into a p-type silicon region, thus forming a source region 13. At the same time, the implanted phosphorus ions are diffused in the silicon substrate 1, and a p-type silicon portion which is in contact with the oxide film 5 in the window 29b is formed into an n-type silicon region, thus forming a source region 2. In addition, a p-type silicon portion which is in contact with the oxide film 5 in the window 29d is formed into an n-type silicon region, thus forming a drain region 11.

In the step shown in Fig. 2M, a resist 32 is formed on the silicon substrate 1, and portions of the oxide film 5 which are in contact with the central portions of the windows 29b and 29d and both the sides of the window 29a (i.e., excluding its central portion) are selectively etched and removed. Arsenic ions are then implanted in each portion, from which the oxide film 5 is removed, so as to have a surface concentration of about $1 \times 10^{20}$ cm⁻³ and a junction depth XJ of 5,000 Å. After the resist 32 is removed, heat treatment of the silicon substrate 1 is performed in a dry oxygen atmosphere at 1,000°C for 30 minutes.

With this heat treatment, the implanted arsenic ions are diffused to form an n⁺-type silicon layer 3b in the n-type silicon region 2, an n⁺-type silicon layer 14a in the p-type silicon region 13, and an n⁺-type silicon layer 11a in the n-type silicon region 11. At the same time, the exposed portions of the silicon layer are oxidized, and new oxide films are respectively formed on the central portion of the window 29b, on both the sides of the window 29a excluding its central portion, and in the window 29d.

In the step shown in Fig. 2N, a resist 33 is formed on the silicon substrate 1 so as to open the central portion of the window 29a, both sides of the window 29b (excluding its central portion) in the p-type silicon region 2, and the drain electrode extraction portion 29c. Subsequently, boron ions are implanted to a surface concentration of about $5 \times 10^{19}$ cm⁻³ and a junction depth Xj of 7,000 Å.

In the step shown in Fig. 20, the resist 33 is removed from the silicon substrate 1. A new oxide film 35 is formed on the oxide film 5 by CVD. Thereafter, heat treatment of the silicon substrate 1 is performed in a nitrogen atmosphere at 1,000°C for 20 minutes.

With this heat treatment, the implanted boron ions are diffused to form a p⁺-type silicon layer 3a in the n⁺-type silicon layer 2, a p⁺-type silicon layer 14b in the p⁺-type silicon layer 13, and a p⁺-type silicon layer 7b in the drain electrode extraction portion.

In addition, as shown in Fig. 1, contact holes 36 are respectively formed in the gates, sources, and drains of both transistors by selective etching. The contact holes 36 are then filled with aluminum or an aluminum alloy, and source, gate, and drain electrodes 4, 6a, and 6b, and the like are formed on the semiconductor substrate 1. Heat treatment of the semiconductor substrate 1 is then performed in a nitrogen atmosphere at 400°C for 10 minutes. As a result, a PSG layer 17 having a thickness of about 1 $\mu$m as a top passivation layer is formed on the uppermost layer of the semiconductor substrate 1. A portion of the PSG layer 17 formed on a bonding pad (not shown) which is formed in advance, is removed, thus exposing the bonding pad.

In the conventional manufacturing process, after the first FET is formed, the second FET is formed, i.e., the first and second FETs are formed in different steps. In the present invention, however, two types of FETs can be formed in a single step. Therefore, the manufacturing method of the present invention allows a greater simplification of the manufacturing process and a greater reduction in the manufacturing cost of a semiconductor device than the conventional method.

Fig. 3 shows current paths of the field effect semiconductor device having the arrangement shown in Fig. 1. Fig. 3 shows a sectional portion equivalent to that of Fig. 1. Arrows e in Fig. 3 indicate the directions of currents. The same reference numerals in Fig. 3 denote the same parts as in Fig. 1. Each conductive body is defined by a p-type or an n-type.

Currents input to the first FET Q1 flow from the source electrode 4 into the silicon substrate 1 as well as a surface portion of the semiconductor substrate 1 through the source region 2 controlled by the gate 6a, thus constituting current paths (allows e) as a drain region. In the conventional device, currents only laterally flow in a limited region formed as current paths in a surface portion of a substrate.

In the present invention, since current paths are also formed in an inner portion of a semiconductor substrate, the ON resistance is reduced to 1/2 or less.

In this embodiment, the field effect semiconductor device described above is designed such that the p-channel DMOS FET as the first FET Q1 is formed in the p-type silicon substrate, and the n-channel DMOS FET as the second FET Q2 is formed in the n-type silicon region which is electrically isolated from the p-type silicon substrate. However, the FETs may have opposite conductivity types to those described above. That is, the present invention can be equally applied to a field effect semiconductor device which is designed such that an n-channel DMOS FET as the first FET Q1 is formed on an n-type silicon substrate, and a p-channel DMOS FET as the second FET Q2 is formed in a p-type silicon region which is electrically isolated from the n-type silicon substrate by a buried layer.

As has been described above, the field effect semiconductor device of the present invention is designed such that the first and second FETs Q1 and Q2 are electrically isolated from each other by one pot-like buried layer. Since only one buried layer is used, reliability of isolation is high, and the buried layer is easy to form. In the device of the present invention, the ON resistance is reduced to 1/2 that of the conventional field effect semiconductor device or less. In addition, the switching speed of the circuit element is increased. Furthermore, if the ON resistance can have the same value as in the conventional device, the gate width of the field effect semiconductor device of the present invention can be reduced to 1/2 that of the conventional device, thus realizing a great reduction in element area and cost. Moreover, in the manufacturing process of the field effect semiconductor device of the present invention, since the source and drain regions of the first and second FETs Q1 and Q2 are simultaneously formed, two types of transistors can be efficiently formed in a single step, thus enabling simplification of the manufacturing process and a reduction in cost. In addition, the impurity concentration of the substrate and the impurity concentration of the epitaxial growth layer can be controlled independently of each other, thereby obtaining an impurity concentration of the drain high resistance layer, which determines the breakdown voltage of each element. Therefore, a drain high resistance layer having a high breakdown voltage can be obtained with base.

The present invention is not limited to the above-described embodiment. Various changes and modifications can be made within the spirit and scope of the invention.

## Claims

1. A field effect semiconductor device having current paths formed in a conductive layer of a semiconductor substrate, comprising:

    a semiconductor substrate of a first conductivity type;

    a pot-like buried layer of a second conductivity type extending from one major surface of said semiconductor substrate of the first conductivity type to the other major surface thereof;

    a semiconductor layer of a second conductivity type, which is formed to fill a space inside said buried layer and is electrically isolated from said semiconductor substrate of the first conductivity type by said buried layer;

    a first field effect transistor formed on one major surface of said semiconductor substrate of the first conductivity type and having a channel of the first conductivity type with current paths of a drain electrode extending through said semiconductor substrate; and

    a second field effect transistor formed on said semiconductor layer and having a channel of the second conductivity type with current paths of the drain electrode extending through said semiconductor layer of the second conductivity type.

2. A device according to claim 1, characterized in that when said semiconductor substrate of the first conductivity type is a p-type semiconductor substrate, said semiconductor layer of the second conductivity type is an n-type semiconductor layer.

3. A device according to claim 1, characterized in that when said semiconductor substrate of the first conductivity type is an n-type semiconductor substrate, said semiconductor layer of the second conductivity type is a p-type semiconductor layer.

4. A device according to claim 1, characterized in that said buried layer has a rectangular shape.

5. A device according to claim 1, characterized in that said buried layer has a semicircular shape.

6. A device according to claim 1, characterized in that a source diffusion layer consisting of a semiconductor of the second conductivity type, opposite to the first conductivity type of said first field effect transistor, is formed on a source region of said first field effect transistor.

7. A device according to claim 1, characterized in that a source diffusion layer of the first conductivity type, opposite to the second conductivity type of said second field effect transistor, is formed on a source region of said second field effect transistor.

8. A device according to claim 1, characterized in that a plurality of second field effect transistors are formed in said semiconductor substrate of the first conductivity type.

F I G. 1

F I G. 2A

F I G. 2B

F I G. 2C

F I G. 2D

F I G. 2E

F I G. 2F

F I G. 2G

F I G. 2H

FIG. 2I

FIG. 2J

FIG. 2K

FIG. 2L

F I G. 2M

F I G. 2N

F I G. 2O

F I G. 3

**European Patent Office**

# EUROPEAN SEARCH REPORT

Application Number

# EP 90 10 4279

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | US-A-4 566 174 (S. YASUDA et al.)<br>* figures; column 3, lines 58-63; claims * | 1-4,8 | H 01 L 21/82<br>H 01 L 21/76 |
| Y | | 5-7 | H 01 L 27/092<br>H 01 L 29/08 |
| Y | US-A-4 138 782 (F.H. DE LA MONEDA et al.)<br>* abstract; figure 2 * | 5 | H 01 L 21/74 |
| Y | PATENT ABSTRACTS OF JAPAN vol. 8, no. 261<br>(E-281)(1698), 30 November 1984;<br>& JP-A-59132671 (NISSAN JIDOSHA) 30.07.1984<br>* abstract; figure * | 6,7 | |
| E | PATENT ABSTRACTS OF JAPAN vol. 14, no. 252<br>(E-934)(4195), 30 May 1990;<br>& JP-A-272662 (TOSHIBA) 12.03.1990<br>* abstract; figure * | 1-8 | |

TECHNICAL FIELDS
SEARCHED (Int. Cl.5)

H 01 L

The present search report has been drawn up for all claims

| Place of search | Date of completion of search | Examiner |
|---|---|---|
| Berlin | 29 October 90 | JUHL A. |